# EUROPÄISCHE PATENTSCHRIFT

(11) **EP 0 809 361 B1**
(45) Veröffentlichungstag und Bekanntmachung des Hinweises auf die Patenterteilung: **30.03.2005**
(21) Anmeldenummer: 97108020.5
(22) Anmeldetag: 16.05.1997
(51) Int. Cl.: H03K 17/945, H03K 17/95, H03K 17/18

(54) **Elektronisches Schaltgerät und Schaltungsanordnung zur Überwachung einer Anlage**
Electronic switching device and circuit arrangement for monitoring a technical installation
Dispositif électronique de commutation et circuit pour la surveillance d'une installation technique

(30) Priorität: 20.05.1996 DE 19619904; 20.05.1996 DE 19620065
(43) Veröffentlichungstag der Anmeldung: 26.11.1997
(73) Patentinhaber: i f m electronic gmbh, D-45127 Essen (DE)
(72) Erfinder: Lamarche, Jean Luc Dipl. Ing., 67206 Mittelhausbergen (FR); Herrmann, Karl, 88239 Wangen-Haslach (DE); Strobel, Manfred Dipl. Ing.(FH), 88250 Weingarten (DE)
(74) Vertreter: Gesthuysen, von Rohr & Eggert

(56) Entgegenhaltungen:
- EP-A- 0 459 478
- DE-A- 3 219 270
- DE-A- 3 340 992
- DE-A- 3 706 325
- US-A- 4 271 763
- US-A- 5 408 132
- US-A- 5 487 448
- PATENT ABSTRACTS OF JAPAN vol. 011, no. 104 (E-494), 2.April 1987 -& JP 61 251324 A (FANUC LTD), 8.November 1986,

## Beschreibung

Die Erfindung betrifft eine Schaltungsanordnung zur Überwachung des fehlerfreien und/oder zur Erkennung eines fehlerhaften Zustandes einer Anlage, z. B. einer Seilbahn- oder Sesselliftanlage, mit einer Mehrzahl von Überwachungs- und Erkennungsgeräten und mit mindestens einer Steuer- und Auswerteeinheit, wobei die Überwachungs- und Erkennungsgeräte als elektronische, berührungslos arbeitende Schaltgeräte ausgeführt sind, wobei die Schaltgeräte einen Anwesenheitsindikator und einen von dem Anwesenheitsindikator - ggf. über einen Schaltverstärker - steuerbaren elektronischen Schalter aufweisen und die Schaltgeräte hinsichtlich ihres Schaltzustandes abfragbar sind, nämlich hinsichtlich ihrer Schalterfunktion - Öffner oder Schließer - durch ein Umsteuersignal umsteuerbar sind.

Elektronische Schaltgerät der hier in Redestehenden Art sind kontaktlos ausgeführt und werden seit fast dreißig Jahren in zunehmendem Maße anstelle von elektrischen, mechanisch betätigten Schaltgeräten, die kontaktbehaftet ausgeführt sind, verwendet, insbesondere in elektrischen bzw. elektronischen Meß-, Steuer- und Regelschaltungen. Das gilt insbesondere für Näherungsschalter, d. h. für elektronische Schaltgeräte, die berührungslos arbeiten. Mit solchen Schaltgeräten wird indiziert, ob sich ein Beeinflussungselement, für das der entsprechende Näherungsschalter sensitiv ist, dem Näherungsschalter hinreichend weit genähert hat. Hat sich nämlich ein Beeinflussungselement, für das der entsprechende Näherungsschalter sensitiv ist, dem Näherungsschalter hinreichend weit genähert, so steuert der Anwesenheitsindikator den elektronischen Schalter um. Bei einem als Schließer ausgeführten Schaltgerät wird der zunächst nichtleitend gewesene elektronische Schalter leitend, während bei einem als Öffner ausgeführten Schaltgerät der zunächst leitend gewesene elektronische Schalter nunmehr sperrt. (Mit Schaltgeräten der in Rede stehenden Art kann auch indiziert werden, ob eine physikalische Größe eines Beeinflussungsmediums, für die das Schaltgerät sensitiv ist, einen entsprechenden Wert erreicht hat.)

Wesentlicher Bestandteil von elektronischen Schaltgeräten ist also u. a. der von außen beeinflußbare Anwesenheitsindikator. Bei induktiven bzw. bei kapazitiven Näherungsschaltern ist als Anwesenheitsindikator in der Regel ein induktiv beeinflußbarer Oszillator bzw. ein kapazitiv beeinflußbarer Oszillator vorgesehen. Optoelektronische Näherungsschalter weisen als Anwesenheitsindikator einen Fotowiderstand, eine Fotodiode oder einen Fototransistor auf. Im übrigen gehören zu den elektronischen Schaltgeräten, mit denen sich die Lehre der Erfindung befaßt, z. B. auch sogenannte Strömungswächter, die eine Temperaturmeßschaltung aufweisen.

Elektronische Schaltgeräte der in Rede stehenden Art sind häufig als sogenannte Zweileiter-Schaltgeräte ausgeführt, d. h. sie sind über einen Außenleiter mit einem Pol einer Spannungsquelle und nur über einen weiteren Außenleiter mit einem Anschluß eines Verbrauchers verbindbar, wobei der andere Anschluß des Verbrauchers an den anderen Pol der Spannungsquelle anschließbar ist.

Bei elektronischen Schaltgeräten, die nur über einen Außenleiter mit einem Pol einer Spannungsquelle und nur über einen weiteren Außenleiter mit einem Anschluß eines Verbrauchers verbindbar sind, ist die Zurverfügungstellung der vom Anwesenheitsindikator und ggf. auch vom Schaltverstärker benötigten Betriebsspannung (= interne Betriebsspannung) bzw. des benötigten Betriebsstroms nicht unproblematisch, weil ja sowohl im leitenden Zustand als auch im gesperrten Zustand des Schaltgeräts die interne Betriebsspannung bzw. der Betriebsstrom zur Verfügung gestellt werden muß.

Es ist belanglos, ob man von der Zurverfügungstellung einer internen Betriebsspannung oder eines Betriebsstroms spricht, weil der Anwesenheitsindikator und ggf. der Schaltverstärker selbstverständlich elektrische Leistung benötigen, also sowohl eine interne Betriebsspannung als auch ein Betriebsstrom benötigt werden (vgl. die Darstellung dieses Sachverhalts in der deutschen Auslegeschrift 23 30 233, insbesondere in Spalte 5, Zeile 68, bis Spalte 6, Zeile 33).

Von ihrer Funktion als Schaltgeräte her soll bei den in Rede stehenden Schaltgeräten im leitenden Zustand praktisch kein Spannungsabfall auftreten und im gesperrten Zustand praktisch kein Reststrom fließen. Da aber dann, wenn bei Zweileiter-Schaltgeräten im leitenden Zustand kein Spannungsabfall aufträte, auch keine interne Betriebsspannung für den Anwesenheitsindikator und ggf. den Schaltverstärker gewonnen werden könnte, und dann, wenn im gesperrten Zustand kein Reststrom flösse, auch kein Betriebsstrom gewonnen werden könnte, gilt für alle Zweileiter-Schaltgeräte, daß im leitenden Zustand ein Spannungsabfall auftritt und im gesperrten Zustand ein Reststrom fließt.

Eingangs ist bereits gesagt worden, daß elektronische Schaltgeräte der in Rede stehenden Art in Meß-, Steuer- und Regelschaltungen verwendet werden. Insbesondere in Steuerschaltungen wird häufig eine Mehrzahl von Schaltgeräten der in Rede stehenden Art benötigt. Dabei können die einzelnen Schaltgeräte relativ weit entfernt voneinander angeordnet sein und können relativ große Entfernungen zwischen den einzelnen Schaltgeräten und einer zentralen Steuerung zu überbrücken sein, so daß sich die Verdrahtung der Schaltgeräte untereinander und mit einer zentralen Steuerung als aufwendig darstellen kann.

Eingangs ist bereits ausgeführt worden, daß Schaltgeräte der in Rede stehenden Art als Schließer oder als Öffner ausgeführt sein können. Bei sicherheitsrelevanten Steuerschaltungen werden als Öffner ausgeführte Schaltgeräte verwendet, weil der sichere Zustand der stromlose Zustand sein muß. Der Einsatz von als Öffner ausgeführten Schaltgeräten der in Rede stehenden Art in sicherheitsrelevanten Steuerschaltungen erfordert die Serienschaltung aller Schaltgeräte. Ist bei einer solchen Serienschaltung auch nur ein als Öffner ausgeführtes Schaltgerät nicht beeinflußt, der zu diesem Schaltgerät gehörende elektronische Schalter als sperrend, so ist der durch die Serienschaltung aller Schaltgeräte gebildete Stromkreis stromlos.

Weiter oben ist bereits dargelegt, daß an Schaltgeräten, die als Zweileiter-Schaltgeräte ausgeführt sind, funktionsnotwendig auch im leitenden Zustand ein Spannungsabfall auftritt; dieser Spannungsabfall kann durchaus in der Größenordnung von 5 - 10 V oder auch darüber liegen. Bei der Serienschaltung von einer Mehrzahl von Schaltgeräten der in Rede stehenden Art kann der insgesamt an der Serienschaltung dieser Schaltgeräte auftretende Spannungsabfall ohne weiteres einen Wert annehmen, der nicht mehr hinnehmbar ist.

Elektronische Schaltgeräte der hier in Rede stehenden Art sind, wie eingangs ausgeführt, kontaktlos ausgeführt. Anstelle des bei einem elektrischen Schaltgerät vorgesehenen Kontaktes ist ein elektronischer Schalter vorgesehen. Auch bei solchen Schaltgeräten der in Rede stehenden Art, die nicht als Zweileiter-Schaltgeräte, sondern als Dreileiter-Schaltgeräte ausgeführt sind, tritt im leitenden Zustand ein nicht vernachlässigbarer Spannungsabfall auf. Auch dieser Spannungsabfall kann sich bei der Serienschaltung von einer Mehrzahl von Schaltgeräten der in Rede stehenden Art zu einem Spannungsabfall addieren, der nicht mehr hinnehmbar ist.

Anlagen der verschiedensten Art, insbesondere sogenannte sicherheitsrelevante Anlagen, bedürfen häufig der ständigen Kontrolle, d. h. es bedarf der Überwachung des fehlerfreien Zustands und - in der Regel in Verbindung mit der Überwachung des fehlerfreien Zustands - der Erkennung eines fehlerbehafteten Zustands. Sobald ein fehlerbehafteter Zustand erkannt worden ist, wird eine sicherheitsrelevante Maßnahme eingeleitet.

Bei Seilbahn- und Sesselliftanlagen ist als sicherheitsrelevanten Kriterium die Lage des Seiles relativ zu den das Seil tragenden bzw. das Seil führenden Seilrollen zu kontrollieren. Entspricht die Ist-Lage des Seiles relativ zu mindestens einer Seilrolle nicht der Soll-Lage, so müssen sicherheitsrelevante Maßnahmen ergriffen werden. Bei einer geringen Abweichung zwischen der Ist-Lage des Seiles und seiner Soll-Lage kann die daraus abgeleitete sicherheitsrelevante Maßnahme eine Reduzierung der Seilgeschwindigkeit sein. Überschreitet die Abweichung zwischen der Ist-Lage des Seiles und der Soll-Lage einen vorgegebenen Grenzwert, so besteht die sicherheitsrelevante Maßnahme jedenfalls darin, daß die Seilbahnanlage bzw. die Sesselliftanlage augenblicklich stillgesetzt wird.

Bei elektrischen - und heute natürlich auch bei elektronischen - Schaltungen, die als Steuerschaltungen funktionieren, unterscheidet man zwischen dem Arbeitsstromprinzip und dem Ruhestromprinzip. Beim Arbeitsstromprinzip wird - z. B. in eine Anlage - dann steuernd eingegriffen, wenn in der Steuerschaltung ein - hinreichend großer - Steuerstrom fließt. In nach dem Arbeitsstromprinzip arbeitenden Steuerschaltungen vorhandene Schaltgeräte sind als Schließer ausgeführt; sie sind elektrisch leitend, wenn sie betätigt sind. Im Gegensatz dazu wird beim Ruhestromprinzip - z. B. in eine Anlage - dann steuernd eingegriffen, wenn in der Steuerschaltung kein Steuerstrom fließt. In nach dem Ruhestromprinzip arbeitenden Steuerschaltungen vorhandene Schaltgeräte sind als Öffner ausgeführt; sie sind elektrisch nicht-leitend, wenn sie betätigt sind.

Bei nach dem Arbeitsstromprinzip aufgebauten Steuerschaltungen wird, wie zuvor ausgeführt, nur dann in eine zugeordnete Anlage steuernd eingegriffen, wenn in der Steuerschaltung ein - hinreichend großer - Steuerstrom fließt. Voraussetzung dafür ist also, daß einerseits die notwendige Betriebsspannung vorhanden ist, daß andererseits kein Leitungsbruch vorliegt und daß schließlich das in einer solchen Steuerschaltung vorhandene, als Schließer ausgeführte Schaltgerät funktionstüchtig ist. Im Gegensatz dazu wird bei einer nach dem Ruhestromprinzip arbeitenden Steuerschaltung dann in eine dazu gehörende Anlage steuernd eingegriffen, wenn in der Steuerschaltung kein Steuerstrom fließt.

Die zuvor gemachten Ausführungen zum Arbeitsstromprinzip und zum Ruhestromprinzip machen deutlich, daß Steuerschaltungen, die sicherheitsrelevante Maßnahmen auslösen sollen, nach dem Ruhestromprinzip arbeiten müssen. Da dabei der stromlose Zustand in der Steuerschaltung so ausgewertet wird, daß die entsprechende Anlage im sicheren Zustand ist, führt ein Ausfall der Betriebsspannung und ein Leitungsbruch stets dazu, daß die Anlage, falls sie sich nicht im sicheren Zustand befindet, in den sicheren Zustand gebracht wird. Bei einer Seilbahnanlage bzw. bei einer Sesselliftanlage ist der sichere Zustand natürlich der abgeschaltete Seilantrieb.

Bei nach dem Arbeitsstromprinzip funktionierenden Steuerschaltungen, also bei Steuerschaltungen, bei denen die Schaltgeräte als Schließer ausgeführt sind, sind die Schaltgeräte parallelgeschaltet; nach dem Betätigen eines als Schließer ausgeführten Schaltgerätes wird die Steuerschaltung insgesamt wirksam. Demgegenüber sind bei nach dem Ruhestromprinzip funktionierenden Steuerschaltungen, also bei Steuerschaltungen, bei denen die Schaltgeräte als Öffner ausgeführt sind, die Schaltgeräte in Serie geschaltet; nach dem Betätigen eines als Öffner ausgeführten Schaltgerätes wird die Steuerschaltung stromlos und damit insgesamt wirksam.

Damit nun bei einer Schaltungsanordnung der in Rede stehenden Art dann, wenn durch die Serienschaltung aller Schaltgeräte ein fehlerhafter Zustand der Anlage erkannt worden ist, der Fehler lokalisiert werden kann, ist vorgesehen, daß die als Schaltgeräte ausgeführten Überwachungs- und Erkennungsgeräte hinsichtlich ihres Schaltzustandes abfragbar sind.

Eine solche Schaltungsanordnung zur Überwachung des fehlerfreien und/ oder zur Erkennung eines fehlerbehafteten Zustands einer Anlage ist aus der DE 37 06 325 A1 bekannt. Bei dieser bekannten Schaltungsanordnung sind einerseits die Überwachungs- und Erkennungsgeräte parallel an einen gemeinsamen Bus angeschlossen und andererseits die Überwachungs- und Erkennungsgeräte miteinander und mit der Steuer- und Auswerteeinheit in Serie an eine Freigabeleitung angeschlossen, die in jedem Überwachungs- und Erkennungsgerät durch einen als Schließer betriebenen Schalter unterbrechbar ist. Unterbricht dieser als Schließer betriebene Schalter in einem der Überwachungs- und Erkennungsgeräte die Freigabeleitung, so wird bei der bekannten Schaltungsanordnung entweder verhindert, daß der Betrieb aufgenommen wird, oder, bei laufendem Betrieb, die Anlage außer Betrieb gesetzt.

Bei der aus der deutschen Offenlegungsschrift 37 06 325 A1 bekannten Schaltungsanordnung erfolgt der parallele Anschluß der Überwachungs- und Erkennungsgeräte an einen Bus beispielsweise über einen bekannten Zweidrahtbus. Der beschriebene Bus ermöglicht unter anderem die Abfrage des Schaltzustandes der Überwachungsund Erkennungsgeräte in dem über ihn entsprechende Daten angefordert werden.

Die bekannte Schaltungsanordnung weist insbesondere beim Einsatz in Verbindung mit Anlagen, die besonders hohe Sicherungsanforderungen stellen, Probleme auf. Zunächst ist problematisch, daß bei einer Abfrage des Schaltzustandes der Überwachungs- und Erkennungsgeräte über den Bus, Defekte in dem angesprochenen Überwachungs- und Erkennungsgerät dazu führen können, daß dies den falschen Schaltzustand über den Bus angibt. Darüber hinaus ist ein parallel mit den Überwachungs- und Erkennungsgeräten verbundener Bus dahingehend problematisch, daß die Leitungslänge begrenzt ist, daß die Vergabe von Adressen über den Bus nicht möglich ist und daß Adressierungsfehler dann möglich sind, wenn mehrere Teilnehmer fälschlicherweise die gleiche Adresse haben.

Aus der US 5,487,448 A ist eine eingangs beschriebene Schaltungsanordnung bekannt, bei der die Schaltgeräte zur Lokalisierung eines aufgetretenen Fehlers hinsichtlich ihrer Schalterfunktion - Öffner oder Schließer - durch ein Umsteuersignal umsteuerbar sind. Die bekannten Sicherheitskette weist eine Vielzahl von Magnetfeldsensoren auf, die jeweils mit einer Sensorelektronik verbunden sind und über separate Spannungsversorgung versorgt werden. Um eine Prüfmöglichkeit der Magnetfeldsensoren zu schaffen, ist jedem Magnetfeldsensor eine Magnetspule zugeordnet, die durch ein entsprechendes Prüfsignal aktivierbar ist und so ein Umschalten des Magnetfeldsensors bzw. eines in der Sensorelektronik angeordneten Umschalters bewirkt.

Der Erfindung liegt die Aufgabe zugrunde, die Schaltungsanordnung zur Überwachung eines fehlerfreien und/oder zur Erkennung eines fehlerbehafteten Zustands einer Anlage, von der die Erfindung ausgeht, so auszugestalten und weiterzubilden, daß die Überwachung besonders hohe Sicherheitsanforderungen erfüllt und eine besonders einfache Anordnung der einzelnen Schaltgeräte auch bei einer Vielzahl von räumlich getrennten Schaltgeräten möglich ist.

Die erfindungsgemäße Schaltungsanordnung, bei dem die zuvor hergeleitete und aufgezeigte Aufgabe gelöst ist, ist dadurch gekennzeichnet, daß die Schaltgeräte miteinander und mit der Steuer- und Auswerteschaltung in Serie geschaltet sind, daß bei allen Schaltgeräten der elektronische Schalter ausgangsseitig an einen Eingang eines UND-Gliedes angeschlossen ist und der andere Eingang des UND-Gliedes einen Steuereingang und der Ausgang des UND-Gliedes den Ausgang des Schaltgerätes darstellen und daß der Ausgang des ersten Schaltgerätes mit dem Steuereingang des zweiten Schaltgerätes, der Ausgang des zweiten Schaltgerätes mit dem Steuereingang des dritten Schaltgerätes und der Ausgang des (n-1)-ten Schaltgerätes mit dem Steuereingang des n-ten Schaltgerätes verbunden sind.

Dadurch, daß die Schaltgeräte miteinander und mit der Steuer- und Auswerteschaltung in Serie geschaltet sind, ist eine Schaltungsanordnung realisierbar, die insgesamt nach dem Ruhestromprinzip funktioniert, so daß ein Ausfall der Betriebsspannung und ein Leitungsbruch stets dazu führt, daß die Anlage, falls sie sich nicht im sicheren Zustand befindet, in den sicheren Zustand gebracht wird.
Im Sinne der zuvor verwendeten Terminologie - Steuereingang, Ausgang - stellt bei den elektronischen Schaltgeräten, von denen die Erfindung ausgeht, der elektronische Schalter praktisch den Ausgang des Schaltgerätes dar; über den elektronischen Schalter fließt der Laststrom des Stromkreises, in dem das elektronische Schaltgerät vorgesehen ist. Genau genommen hat der elektronische Schalter natürlich zwei Laststromführungsanschlüsse (und in der Regel einen Steueranschluß) und ist einer dieser beiden Laststromführungsanschlüsse der Laststromausgang, hier Ausgang genannt. Wenn es zuvor geheißen hat, daß der elektronische Schalter an einen Eingang eines UND-Gliedes angeschlossen ist, so ist also damit gemeint, daß der Laststromführungsanschluß des elektronischen Schalters, der bei den bekannten elektronischen Schaltgeräten, von denen die Erfindung ausgeht, den Ausgang des Schaltgerätes darstellt, an einen Eingang eines UND-Gliedes angeschlossen ist. Der andere Eingang des UND-Gliedes stellt einen Steuereingang für das elektronische Schaltgerät dar, den es bei den bekannten elektronischen Schaltgeräten, von denen die Erfindung ausgeht, nicht gibt. Bei dem elektronischen Schaltgerät der erfindungsgemäßen Schaltungsanordnung entspricht der Ausgang des UND-Gliedes funktionell dem Laststromführungsanschluß des elektronischen Schalters des bekannten elektronischen Schaltgerätes, der bei diesem bekannten elektronischen Schaltgerät den Ausgang des Schaltgerätes insgesamt darstellt.

Man kann das elektronische Schaltgerät der erfindungsgemäßen Schaltungsanordnung auch dahingehend beschreiben, daß es aus einem bekannten elektronischen, berührungslos arbeitenden Schaltgerät und zusätzlich aus einem UND-Glied besteht, wobei der Ausgang des bekannten elektronischen Schaltgerätes an einen Eingang des zusätzlichen UND-Gliedes angeschlossen ist, der andere Eingang des zusätzlich vorhandenen UND-Gliedes einen zusätzlichen Steuereingang darstellt und der Ausgang des UND-Gliedes den Ausgang des Schaltgerätes darstellt, den bei dem bekannten Schaltgerät einer der beiden Laststromführungsanschlüsse des elektronischen Schalters darstellt.

Der Klarstellung bzw. Erläuterung bedarf noch der Begriff "UND-Glied". Hierunter soll im Rahmen der Erfindung jedes Bauelement bzw. jede Schaltung verstanden werden, die dann einen "leitenden Ausgang" - wie der leitende Ausgang eines bekannten elektronischen Schaltgerätes - hat, wenn an beiden Eingängen ein über einer Ansprechschwelle liegendes Steuersignal anliegt. Im übrigen muß das UND-Glied bei dem elektronischen Schaltgerät so ausgeführt sein, daß dann, wenn an seinen beiden Eingängen ein über einer Ansprechschwelle liegendes Eingangssignal liegt, über das UND-Glied der Laststrom des Stromkreises fließen kann, in dem das elektronische Schaltgerät vorgesehen ist. Das UND-Glied ersetzt ja funktionell den elektronischen Schalter, der bei den bekannten Schaltgeräten, von denen die Erfindung ausgeht, den Laststrom des Stromkreises führt, in dem ein solches Schaltgerät vorgesehen ist.

Aus dem, was zuvor in bezug auf das UND-Glied gesagt worden ist, folgt, daß der Spannungsabfall, der am leitenden Schaltgerät auftritt, der Spannungsabfall ist, der an dem - gleichsam als elektronischer Schalter wirkenden - UND-Glied auftritt. Diese Ausbildung des Schaltgerätes und die zuvor angegebene "Pseudo-Serienschaltung" der Schaltgeräte führt nun dazu, daß sich die Spannungsabfälle an jedem Schaltgerät nicht aufsummieren. Unabhängig davon, welche Anzahl an Schaltgeräten die in Rede stehende "Pseudo-Serienschaltung" bilden, ist der insgesamt auftretende Spannungsabfall gleich dem Spannungsabfall, der an einem Schaltgerät auftritt.

Dient die erfindungsgemäße Schaltungsanordnung z. B. zur Überwachung des fehlerfreien und zur Erkennung eines fehlerbehafteten Zustandes einer Seilbahnanlage oder einer Sesselliftanlage, dann können zu einer solchen Schaltungsanordnung ohne weiteres fünfzig oder mehr Überwachungs- und Erkennungsgeräte gehören, - über mehrere hundert Meter verteilt angeordnet. Dadurch, daß die Überwachungsund Erkennungsgeräte hinsichtlich ihres Zustandes abfragbar sind, kann dann, wenn ein fehlerhafter Zustand erkannt worden ist, festgestellt werden, wo der Fehler aufgetreten ist, so daß der Fehler dann ohne weiteres behoben werden kann.

Damit nun die für die erfindungsgemäße Schaltungsanordnung wesentliche Serienschaltung der als Schaltgeräte der zuvor beschriebenen Art ausgeführten Überwachungs- und Erkennungsgeräte nicht zu einem nicht hinnehmbaren Spannungsabfall führt, ist erfindungsgemäß bei allen als elektronische Schaltgeräte ausgeführten Überwachungs- und Erkennungsgeräten der elektronische Schalter ausgangsseitig an einen Eingang eines UND-Gliedes angeschlossen ist, der andere Eingang des UND-Gliedes einen Steuereingang des Schaltgerätes darstellt, der Ausgang des UND-Gliedes den Ausgang des Schaltgerätes darstellt und der Ausgang des ersten Schaltgerätes mit dem Steuereingang des zweiten Schaltgerätes, der Ausgang des zweiten Schaltgerätes mit dem Steuereingang des dritten Schaltgerätes, und der Ausgang des (n-1)-ten Schaltgerätes mit dem Steuereingang des n-ten Schaltgerätes verbunden sind.

Gemäß einer bevorzugten Ausgestaltung der Erfindung sind bei der erfindungsgemäßen Schaltungsanordnung die Schaltgeräte nicht nur hinsichtlich ihres Schaltzustandes abfragbar, sondern zusätzlich adressierbar. Damit ist gemeint, daß jedes einzelne Schaltgerät dadurch individualisiert ist, daß ihm eine bestimmte Adresse zugeordnet ist. Für das Abfragen des Zustandes eines bestimmten Schaltgerätes wird also das durch seine Adresse individualisierte Schaltgerät "angesprochen" und dann sein Schaltzustand abgefragt.

Grundsätzlich besteht die Möglichkeit, die Schaltgeräte der erfindungsgemäßen Schaltungsanordnung an einen Bus anzuschließen und über den Bus die einzelnen Schaltgeräte anzusprechen und hinsichtlich ihres Zustandes abzufragen. Bei einer bevorzugten Ausführungsform der erfindungsgemäßen Schaltungsanordnung bilden jedoch die Schaltgeräte und die Steuer- und Auswerteeinheit hinsichtlich der Abfrage- und Adressiermöglichkeit - über entsprechende Verbindungsleitungen - einen Ring.

Bei einer bevorzugten Ausführungsform der erfindungsgemäßen Schaltungsanordnung weisen die Schaltgeräte und die Steuer- und Auswerteeinheit jeweils eine Telegrammeinheit auf. Zweckmäßigerweise sind dabei die Telegrammeinheiten der Schaltgeräte so ausgeführt, daß in ihnen eine Adresse speicherbar ist, daß sie ein empfangenes Telegramm bearbeiten können und daß sie ein empfangenes Telegramm ggf. nach Bearbeitung, senden können. Bilden die Schaltgeräte und die Steuer- und Auswerteeinheit hinsichtlich der Abfrage- und Adressiermöglichkeit einen Ring, so gilt folgendes:

Die Steuer- und Auswerteeinheit generiert ein Telegram, das von der Steuer- und Auswerteeinheit - über eine Verbindungsleitung - zur Telegrammeinheit des ersten Schaltgerätes gelangt; die Steuer- und Auswerteeinheit sendet also ein Telegramm an das erste Schaltgerät. Dieses Telegramm, das im einzelnen weiter unten noch beschrieben wird, enthält einerseits eine Adressen-Information, andererseits weitere Informationen. In der Telegrammeinheit des ersten Schaltgerätes wird das von der Steuer- und Auswerteeinheit kommende Telegramm dann, wenn die in ihm enthaltene Adressen-Information der Adresse des ersten Schaltgerätes entspricht, bearbeitet. Danach wird das bearbeitete Telegramm von der Telegrammeinheit des ersten Schaltgerätes weitergegeben an die Telegrammeinheit des zweiten Schaltgerätes usw. Die Telegrammeinheiten der Schaltgeräte sind also Telegrammempfangs-, -bearbeitungs- und -sendeeinheiten, während die Telegrammeinheit der Steuer- und Auswerteeinheit eine Telegrammgenerier-, -sende-, empfangs- und -auswerteeinheit ist. Die Steuer- und Auswerteeinheit kann auch zwei unterschiedliche Telegrammeinheiten aufweisen, nämlich einerseits eine Telegrammgenerier- und -sendeeinheit und andererseits eine Telegrammempfangs- und -auswerteeinheit.

Wie bisher beschrieben, weisen bei der erfindungsgemäßen Schaltungsanordnung die Schaltgeräte funktionsnotwendig einen Ausgang und vorzugsweise die zuvor im einzelnen beschriebene Telegrammeinheit auf. Darüber hinaus können die Schaltgeräte noch einen - nicht sicherheitsrelevanten - Informationsausgang aufweisen, wobei die Informationsausgänge aller Schaltgeräte miteinander und mit der Steuer- und Auswerteeinheit verbunden sind.

Wie bei einer erfindungsgemäßen Schaltungsanordnung die Schaltgeräte im einzelnen ausgebildet sind, hängt vor allem davon ab, wie die Anlage im einzelnen ausgeführt ist, bei der mit Hilfe der erfindungsgemäßen Schaltungsanordnung der fehlerfreie Zustand überwacht und ein fehlerbehafteter Zustand erkannt werden soll. Handelt es sich bei dieser Anlage um eine Seilbahn- oder Sesselliftanlage, so kann es zweckmäßig sein, daß jedes Schaltgerät drei Anwesenheitsindikatoren aufweist und die Anwesenheitsindikatoren ausgangsseitig - direkt oder indirekt - miteinander logisch verknüpft sind.

Im einzelnen gibt es nun verschiedene Möglichkeiten, die erfindungsgemäße Schaltungsanordnung auszugestalten und weiterzubilden. Solche Ausgestaltungen und Weiterbildungen ergeben sich aus dem Patentanspruch 1 nachgeordneten Patentansprüchen und aus der folgenden Beschreibung von Ausführungsbeispielen in Verbindung mit der Zeichnung. In der Zeichnung zeigt
- Fig. 1: schematisch, ein Ausführungsbeispiel eines Schaltgerätes einer Schaltungsanordnung,
- Fig. 2: eine Schaltungsanordnung mit einer Mehrzahl von Schaltgeräten,
- Fig. 3: schematisch, ein erstes bevorzugtes Ausführungsbeispiel einer erfindungsgemäßen Schaltungsanordnung,
- Fig. 4: ein zweites bevorzugtes Ausführungsbeispiel einer erfindungsgemäßen Schaltungsanordnung und
- Fig. 5: schematisch, einen Ausschnitt aus einer Seilbahn- oder Sesselliftanlage, bei der die erfindungsgemäße Schaltungsanordnung eingesetzt ist.

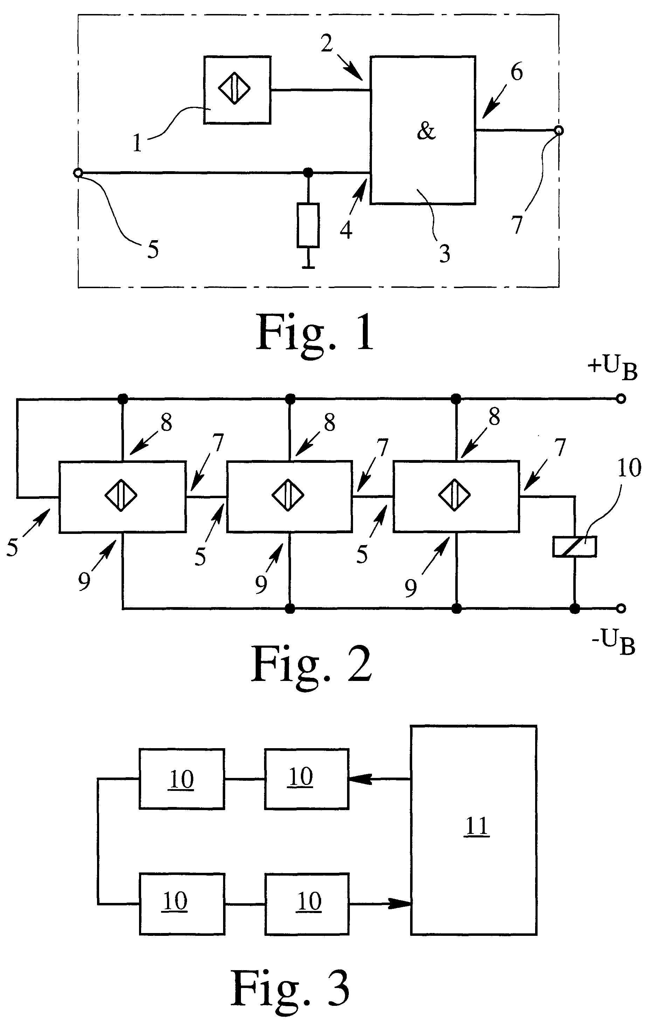

Die Fig. 1 zeigt, stark schematisiert, ein elektronisches, nämlich berührungslos arbeitendes Schaltgerät, mit einem nicht dargestellten Anwesenheitsindikator, z. B. einem Oszillator, und mit einem von dem Anwesenheitsindikator - ggf. über einen nicht dargestellten Schaltverstärker - steuerbaren, ebenfalls nicht dargestellten elektronischen Schalter. Bestandteil des elektronischen Schaltgerätes ist also zunächst ein üblicher, hinlänglich bekannter induktiver Näherungsschalter 1.

Wie die Fig. 1 zeigt, ist der induktive Näherungsschalter 1 ausgangsseitig an einen Eingang 2 eines UND-Gliedes 3 angeschlossen. Durch den anderen Eingang 4 des UND-Gliedes 3 werden ein Steuereingang 5 und durch den Ausgang 6 des UND-Gliedes 3 der Ausgang 7 des Schaltgerätes dargestellt.

Bei den elektronischen Schaltgeräten, von denen die Erfindung ausgeht, stellt der elektronische Schalter praktisch den Ausgang des Schaltgerätes dar; über den elektronischen Schalter fließt der Laststrom des Stromkreises, in dem das elektronische Schaltgerät vorgesehen ist. Der elektronische Schalter hat natürlich zwei Laststromführungsanschlüsse (und in der Regel einen Steueranschluß), wobei einer dieser beiden Laststromführungsanschlüsse der Laststromausgang ist, hier Ausgang genannt. Berücksichtigt man dies, dann gilt für das in Fig. 1 dargestellte elektronische Schaltgerät auch, daß der elektronische Schalter - mit seinem Laststromausgang - an den Eingang 2 des UND-Gliedes 3 angeschlossen ist. Die bekannten elektronischen Schaltgeräte, von denen die Erfindung ausgeht, weisen einen Steuereingang der Art nicht auf, der bei dem elektronischen Schaltgerät in Form des anderen Eingangs 4 des UND-Gliedes 3 vorgesehen ist. Der bei dem elektronischen Schaltgerät vorgesehene Ausgang 7, dargestellt durch den Ausgang 6 des UND-Gliedes 3, entspricht dem Laststromführungsanschluß des elektronischen Schalters des bekannten elektronischen Schaltgerätes, der bei diesem bekannten elektronischen Schaltgerät insgesamt den Ausgang des Schaltgerätes darstellt.

Die Fig. 2 zeigt nun eine erfindungsgemäße Schaltungsanordnung mit einer Mehrzahl von Schaltgeräten, beispielsweise nach Fig. 1; konkret sind bei der in Fig. 2 dargestellten Schaltungsanordnung drei Schaltgeräte vorgesehen. Dabei sind der Ausgang 7 des ersten Schaltgerätes mit dem Steuereingang 5 des zweiten Schaltgerätes und der Ausgang 7 des zweiten Schaltgerätes mit dem Steuereingang 5 des dritten Schaltgerätes verbunden.

Für das elektronische Schaltgerät gilt, daß das UND-Glied 3 dann einen leitenden Ausgang 6 hat, der Ausgang 7 des Schaltgerätes also leitend ist, wenn an den beiden Eingängen 2 und 4 des UND-Gliedes 3 ein über einer Ansprechschwelle liegendes Steuersignal anliegt. Dieses Steuersignal kommt einerseits, und zwar an den Eingang 2 des UND-Gliedes 3, vom nicht dargestellten elektronischen Schalter, also praktisch vom Ausgang des induktiven Näherungsschalters 1, wird andererseits, und zwar an den Eingang des UND-Gliedes 3, über den Steuereingang 5 zugeführt.

Bei dem elektronischen Schalter der erfindungsgemäßen Schaltungsanordnung ersetzt, gleichsam von außen gesehen, das UND-Glied 3 funktionell den elektronischen Schalter, der bei den bekannten Schaltgeräten, von denen die Erfindung ausgeht, den Laststrom des Stromkreises führt, in dem ein solches Schaltgerät vorgesehen ist. Über das UND-Glied 3 des elektronischen Schaltgerätes fließt also der Laststrom des Stromkreises, in dem das elektronische Schaltgerät vorgesehen ist.

Für dieses elektronische Schaltgerät gilt, daß der Spannungsabfall, der am leitenden Schaltgerät auftritt, der Spannungsabfall ist, der an dem - gleichsam als elektronischer Schalter wirkenden - UND-Glied 3 auftritt.

Die Ausbildung des Schaltgerätes und die in Fig. 2 dargestellte "Pseudo-Serienschaltung" von mehreren Schaltgeräten führt dazu, daß sich die Spannungsabfälle an jedem Schaltgerät nicht aufsummieren. Unabhängig davon, welche Anzahl Schaltgeräte die in Fig. 2 dargestellte "Pseudo-Serienschaltung" bilden, ist der insgesamt auftretende Spannungsabfall gleich dem Spannungsabfall, der an einem Schaltgerät auftritt.

Hinsichtlich der in Fig. 2 dargestellten Schaltungsanordnung mit einer Mehrzahl von Schaltgeräten ist noch darauf hinzuweisen, daß hier dargestellt ist, daß jedes Schaltgerät - neben dem Steuereingang 5 und dem Ausgang 7 - zwei Spannungs- bzw. Stromversorgungsanschlüsse 8, 9 aufweist, die in Fig. 1 nicht dargestellt sind. Der Steuereingang 5 des ersten Schaltgerätes liegt, wie die Spannungs- bzw. Stromversorgungsanschlüsse 8, am Pluspol der Versorgungsspannung U_{B}. Zwischen dem Ausgang 7 des dritten, also des letzten Schaltgerätes und dem Minuspol der Versorgungsspannung U_{B} ist als Last ein Relais 10 vorgesehen. Sind alle Schaltgeräte beeinflußt, also alle elektronischen Schalter der einen Bestandteil der elektronischen Schaltgeräte bildenden induktiven Näherungsschalter 1 leitend, dann sind auch alle UND-Glieder 3 leitend und vom Pluspol der Versorgungsspannung U_{B} fließt über das UND-Glied 3 des letzten Schaltgerätes und das Relais 11 der Laststrom.

Schließlich sei noch darauf hingewiesen, daß bei Einsatz der Schaltgeräte in einer erfindungsgemäßen Schaltungsanordnung gemäß Fig. 2 die Funktionsfähigkeit aller Schaltgeräte einfach überprüft werden kann, nämlich dadurch daß das erste Schaltgerät zur Überprüfung der Funktionsfähigkeit aller Schaltgeräte beeinflußt wird. Wenn auch nur ein Schaltgerät nicht in Ordnung ist, so ist dann auch das letzte Schaltgerät nicht leitend.

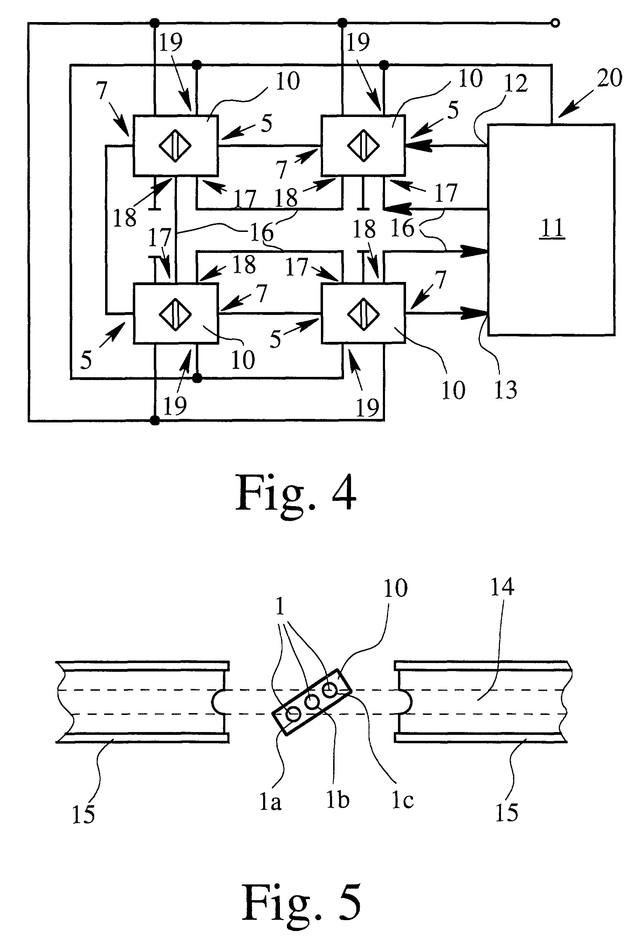

Die in den Fig. 3 und 4 dargestellte Schaltungsanordnung ist bestimmt zur Überwachung des fehlerfreien und zur Erkennung eines fehlerbehafteten Zustands einer Anlage, z. B. einer nur schematisch und ausschnittsweise in Fig. 5 angedeuteten Seilbahn- oder Sesselliftanlage, und besteht in ihrem grundsätzlichen Aufbau aus einer Mehrzahl von Schaltgeräten 10, die als Überwachungs- und Erkennungsgeräte dienen, und aus einer Steuer- und Auswerteeinheit 11. Die Schaltgeräte 10 sind miteinander und mit der Steuer- und Auswerteeinheit 11 in Serie geschaltet.

In den Fig. 3 und 4 sind jeweils nur vier Schaltgeräte 10 dargestellt. In der Regel gehört jedoch zu der erfindungsgemäßen Schaltungsanordnung eine Vielzahl von Schaltgeräten 10; bei einer Schaltungsanordnung zur Überwachung des fehlerfreien und zur Erkennung eines fehlerbehafteten Zustands einer Seilbahn- oder Sesselliftanlage können ohne weiteres - über mehrere hundert Meter verteilt - fünfzig oder mehr Schaltgeräte 10 erforderlich sein.

Damit nun dann, wenn durch die Serienschaltung aller Schaltgeräte 10 ein fehlerhafter Zustand der Anlage, z. B. einer Seilbahn- oder Sesselliftanlage, erkannt worden ist, der aufgetretene Fehler ohne weiteres lokalisiert werden kann, ist erfindungsgemäß vorgesehen, daß die Schaltgeräte 10 hinsichtlich ihres Zustandes abfragbar sind.

Wie die zu einer erfindungsgemäßen Schaltungsanordnung gehörenden Schaltgeräte 10 im einzelnen ausgeführt sind, hängt davon ab, welcher Art die zugehörige Anlage ist. In vielen Fällen können die Schaltgeräte 10 als elektronische, berührungslos arbeitende Schaltgeräte, insbesondere als induktive oder kapazitive Näherungsschalter, ausgeführt sein. Handelt es sich bei der Anlage, bei der der fehlerfreie Zustand überwacht und ein fehlerhafter Zustand erkannt werden soll, um eine Seilbahn- oder Sesselliftanlage, so können die Schaltgeräte 10 insbesondere als induktive Näherungsschalter ausgeführt sein. Solche induktiven Näherungsschalter weisen einen Anwesenheitsindikator, nämlich einen Oszillator, und einen von dem Anwesenheitsindikator, also dem Oszillator - in der Regel über einen Schaltverstärker - steuerbaren elektronischen Schalter auf. Elektronische, berührungslos arbeitende Schaltgeräte, insbesondere induktive und kapazitive Näherungsschalter, sind hinlänglich bekannt und bedürfen hier nicht der detaillierten Beschreibung.

Aus den eingangs erläuterten Gründen - als sicherheitsrelevante Schaltungsanordnung Ruhestromprinzip - sind die Schaltgeräte 10 miteinander und mit der Steuerund Auswerteeinheit 11 in Serie geschaltet. Deshalb gehören zu den dargestellten bevorzugten Ausführungsbeispielen erfindungsgemäßer Schaltungsanordnungen besonders ausgebildete Schaltgeräte 10, wie das schematisch in Fig. 1 dargestellt ist. Bestandteil der Schaltgeräte 10 ist nämlich zunächst ein üblicher, hinlänglich bekannter induktiver Näherungsschalter 1. Wie die Fig. 1 zeigt, ist der induktive Näherungsschalter 1 ausgangsseitig an einen Eingang 2 eines UND-Gliedes 3 angeschlossen. Durch den anderen Eingang 4 des UND-Gliedes 3 werden ein Steuereingang 5 und durch den Ausgang 6 des UND-Gliedes 3 der Ausgang 7 des Schaltgerätes 10 dargestellt.

Wie Fig. 4 zeigt, sind der Steuerausgang 12 der Steuer- und Auswerteeinheit 11 mit dem Steuereingang 5 des ersten Schaltgerätes 10, der Ausgang 7 des ersten Schaltgerätes 10 mit dem Steuereingang 5 des zweiten Schaltgerätes 10, der Ausgang 7 des zweiten Schaltgerätes 10 mit dem Steuereingang 5 des dritten Schaltgerätes 10, der Ausgang 7 des dritten Schaltgerätes 10 mit dem Steuereingang 5 des vierten Schaltgerätes 10 und der Ausgang 7 des vierten Schaltgerätes 10 mit dem Steuereingang 13 der Steuer- und Auswerteeinheit 11 verbunden.

Wie bereits ausgeführt, gilt für die erfindungsgemäße Schaltungsanordnung, daß die Schaltgeräte 10 hinsichtlich ihres Schaltzustandes abfragbar sind. Dazu sind die Schaltgeräte 10 hinsichtlich ihrer Schalterfunktion - Öffner oder Schließer - durch ein Umsteuersignal umsteuerbar. Des weiteren sind die Schaltgeräte 10 adressierbar; das wird im einzelnen weiter unten noch erläutert.

Bei den, wie zuvor geschehen, beschriebenen und in den Fig. 3 und 4 dargestellten Ausführungsbeispielen erfindungsgemäßer Schaltungsanordnungen erfolgt das Abfragen des Schaltzustandes wie folgt:

Zunächst sei angenommen, daß sich die Seilbahn- oder Sesselliftanlage im fehlerfreien Zustand befindet; die Ist-Lage des in Fig. 5 angedeuteten Seiles 14 relativ zu den in Fig. 5 angedeuteten Seilrollen 15 entspricht der Soll-Lage. Die als Öffner ausgeführten Schaltgeräte 10 sind elektrisch leitend, - weil ein Fehler nicht vorliegt. Folglich ist der durch die Serienschaltung - bzw. der durch die "Pseudo-Serienschaltung" - aller Schaltgeräte 10 und der Steuer- und Auswerteeinheit 11 gebildete Stromkreis geschlossen.

Nun sei angenommen, daß an einer Stelle die Ist-Lage des Seiles 14 von seiner Soll-Lage abweicht. Das wird von dem entsprechenden Schaltgerät 10 als Fehler erkannt. Folglich ist das entsprechende Schaltgerät 10 elektrisch nicht-leitend, - so daß der Stromkreis, der im fehlerfreien Zustand geschlossen ist, nunmehr unterbrochen ist. Das führt mit Hilfe der Steuer- und Auswerteeinheit 11 dazu, daß die Seilbahn- bzw. Sesselliftanlage augenblicklich in den sicheren Zustand gebracht wird; insbesondere wird der Seilantrieb abgeschaltet und abgebremst und das Seil 14 z. B. fixiert. Nun soll der aufgetretene Fehler lokalisiert werden. Dazu werden nacheinander die einzelnen Schaltgeräte 10 "angesprochen" und mit einem Umsteuersignal beaufschlagt. Das Beaufschlagen der Schaltgeräte 10 mit einem Umsteuersignal führt bei allen Schaltgeräten 10, bei denen die Ist-Lage des Seiles 14 mit der Soll-Lage übereinstimmt, dazu, daß das elektrisch leitende Schaltgerät 10 vom elektrisch leitenden in den nicht-leitenden Zustand umgesteuert wird, während das Schaltgerät 10, bei dem die Ist-Lage des Seiles 14 von der Soll-Lage unzulässig abweicht, vom elektrisch nicht-leitenden Zustand in den leitenden Zustand umgesteuert wird. Die Steuer- und Auswerteeinheit 11 erkennt nun das Umsteuern des Schaltgerätes 10, bei dem die Ist-Lage des Seiles 14 von der Soll-Lage unzulässig abweicht, weil das Umsteuern dieses Schaltgerätes 10 dazu führt, daß der durch alle Schaltgeräte 10 und durch die Steuerund Auswerteeinheit 11 gebildete Stromkreis wieder geschlossen ist.

Für das in Fig. 4 dargestellte Ausführungsbeispiel einer erfindungsgemäßen Schaltungsanordnung gilt nun weiter, daß die Schaltgeräte 10 und die Steuer- und Auswerteeinheit 11 hinsichtlich der Abfrage- und Adressiermöglichkeit - über entsprechende Verbindungsleitungen 16 - einen Ring bilden.

Im übrigen gilt für das in Fig. 4 dargestellte Ausführungsbeispiel einer erfindungsgemäßen Schaltungsanordnung, was jedoch im einzelnen nicht dargestellt ist, daß die Schaltgeräte 10 und die Steuer- und Auswerteeinheit 11 jeweils eine Telegrammeinheit aufweisen, wobei die Telegrammeinheiten der Schaltgeräte 10 so ausgeführt sind, daß in ihnen eine Adresse speicherbar ist, daß sie ein empfangenes Telegramm bearbeiten können und daß sie ein empfangenes Telegramm, ggf. nach Bearbeitung senden können. Dabei sind die Telegrammeinheiten der Schaltgeräte 10 nur dann funktionstüchtig, wenn an ihnen ein Freigabesignal anliegt. Dazu weisen die Telegrammeinheiten der Schaltgeräte 10 - zusätzlich zu einem Telegrammeingang 17 und einem Telegrammausgang 18 - jeweils einen Freigabesignaleingang 19 auf. Die Freigabesignaleingänge 19 der Telegrammeinheiten aller Schaltgeräte 10 sind mit einem Freigabesignalausgang 20 der Steuer- und Auswerteeinheit 11 verbunden.

Nicht dargestellt ist, daß die Telegrammausgänge 18 der Telegrammeinheiten aller Schaltgeräte 10 - voneinander entkoppelt - miteinander und mit der Steuer- und Auswerteeinheit 11 verbunden sind, und nicht dargestellt ist auch, daß die Schaltgeräte 10 - zusätzlich zu dem sicherheitsrelevanten Ausgang 7 einen nicht sicherheitsrelevanten Informationsausgang aufweisen, wobei die Informationsausgänge aller Schaltgeräte 10 miteinander und mit der Steuer- und Auswerteeinheit 11 verbunden sind.

Dadurch, daß die Telegrammausgänge 18 der Telegrammeinheiten aller Schaltgeräte 10 mit der Steuer- und Auswerteeinheit 11 verbunden sind, kann die Steuer- und Auswerteeinheit 11 dann, wenn der durch die Schaltgeräte 10 - und die Verbindungsleitungen 16 - eigentlich geschlossene Ring nicht geschlossen ist, erkennen, hinter welchem Schaltgerät 10 der - nicht mehr geschlossene - Ring unterbrochen ist.

Mit Hilfe der bei den Schaltgeräten 10 zusätzlich realisierten, nicht sicherheitsrelevanten Informationsausgänge können Zustände innerhalb der kontrollierten Anlage erfaßt werden, die noch keine sicherheitsrelevanten Maßnahmen erfordern. Beispielsweise kann bei einer Seilbahn- oder Sesselliftanlage erkannt werden, daß die Ist-Lage des Seiles 14 nicht mehr exakt der Soll-Lage entspricht, ohne daß die Abweichung der Ist-Lage von der Soll-Lage so groß ist, daß sicherheitsrelevant eingegriffen werden muß. Beispielsweise kann in einem solchen Fall die Seilgeschwindigkeit reduziert werden.

In Fig. 5 ist nun noch angedeutet, daß jedes Schaltgerät 10 drei Anwesenheitsindikatoren bzw. drei Näherungsschalter 1 aufweisen kann, wobei dann die Anwesenheitsindikatoren bzw. die Näherungsschalter 1 ausgangsseitig - direkt oder indirekt - miteinander logisch verknüpft sind. Für die drei Näherungsschalter 1 soll nun folgendes gelten:
a) Näherungsschalter 1a ist unbedämpft, wenn die Ist-Lage des Seiles 14 die Soll-Lage ist, jedoch bedämpft, wenn die Ist-Lage des Seiles 14 nicht mehr die Soll-Lage ist, die Ist-Lage des Seiles 14 vielmehr in Richtung auf den Näherungsschalter 1a von der Soll-Lage abweicht.
b) Näherungsschalter 1b ist bedämpft, wenn die Ist-Lage des Seiles 14 die Soll-Lage ist, jedoch unbedämpft, wenn die Ist-Lage des Seiles 14 nicht mehr die Soll-Lage ist.
c) Näherungsschalter 1c ist unbedämpft, wenn die Ist-Lage des Seiles 14 die Soll-Lage ist, jedoch bedämpft, wenn die Ist-Lage des Seiles 14 nicht mehr die Soll-Lage ist, die Ist-Lage des Seiles 14 vielmehr in Richtung auf den Näherungsschalter 1c von der Soll-Lage abweicht.

Mit diesen Voraussetzungen gilt folgendes:

Sind alle drei Näherungsschalter 1a, 1b und 1c unbedämpft, so ist das ein sicherheitsrelevantes Kriterium, so daß die Schaltungsanordnung sofort eingreifen muß.

Sind die Näherungsschalter 1a und 1b bedämpft, der Näherungsschalter 1c jedoch unbedämpft, so ist das ein Kriterium dafür, daß die Ist-Lage des Seiles 14 nicht mehr exakt mit der Soll-Lage übereinstimmt. Das gleiche gilt für den Fall, daß die Näherungsschalter 1b und 1c bedämpft sind, während der Näherungsschalter 1a unbedämpft ist.

Ist nur der Näherungsschalter 1a oder nur der Näherungsschalter 1c bedämpft, so ist das ein Kriterium dafür, daß die Ist-Lage des Seiles 14 schon erheblich von der Soll-Lage abweicht.

Sind alle drei Näherungsschalter 1a, 1b und 1c bedämpft, so ist das ein nicht definierter Zustand. Auch in diesem Fall muß die Schaltungsanordnung sofort eingreifen.

Sind die Näherungsschalter 1a und 1c unbedämpft, der Näherungsschalter 1b jedoch bedämpft, so ist das das Kriterium dafür, daß die Ist-Lage des Seiles 14 mit der Soll-Lage übereinstimmt.

Im folgenden soll nun noch erläutert werden, wie bei dem in Fig. 4 dargestellten bevorzugten Ausführungsbeispiel einer erfindungsgemäßen Schaltungsanordnung die Telegramme aussehen können und wie diese Telegramme von den Schaltgeräten 10 vorhandenen Telegrammeinheiten empfangen, bearbeitet und gesendet werden können. Dabei wird vorausgesetzt,
a) daß jedes Telegramm aus zwei Telegrammbestandteilen - mit einer beliebigen Anzahl von Bits - besteht,
b) daß der erste Telegrammbestandteil eines von der Steuer- und Auswerteeinheit 11 kommenden Telegramms den Adressierbefehl A enthalten kann und dann, wenn der erste Telegrammbestandteil den Adressierbefehl A enthält, der zweite Telegrammbestandteil eine Adresse B enthält und die Adresse B gespeichert werden soll, - es sei denn, sie ist bereits gespeichert,
c) daß im übrigen in jedem Telegramm der erste Telegrammbestandteil eine Adresse B darstellt und der zweite Telegrammbestandteil entweder einen Bearbeitungsbefehl C oder die Zustandsinformation D des entsprechenden Überwachungs- und Erkennungsgerätes 1 enthält,
d) daß dann, wenn der erste Telegrammbestandteil eine Adresse B enthält und das empfangende Schaltgerät 10 genau diese Adresse B hat, von dem "angesprochenen" Schaltgerät 10 ein Telegramm gesendet wird, dessen erster Telegrammbestandteil die Adresse B des sendenden Schaltgerätes 10 enthält und dessen zweiter Telegrammbestandteil die Zustandsinformation D des sendenden Schaltgerätes 10 und eine Zusatzinformation E "Telegramm bearbeitet" enthält und
e) daß dann, wenn die Telegrammeinheit eines Schaltgerätes 10 ein Telegramm empfängt, dessen erster Telegrammbestandteil seine Adresse B und dessen zweiter Telegrammbestandteil die Zusatzinformation E enthält, die Telegrammeinheit dieses Schaltgerätes 10 ein Telegramm sendet, dessen erster Telegrammbestandteil die Adressierinformation F "Adressierfehler" und dessen zweiter Telegrammbestandteil die Adresse B enthält.

Damit sind dann u. a. folgende Telegramm- und Bearbeitungssituationen möglich:
1. Das erste Schaltgerät 10 (oder ein x-beliebiges Schaltgerät 10) soll nicht adressiert sein. Die Steuer- und Auswerteeinheit 11 sendet ein Telegramm, dessen erster Telegrammbestandteil den Adressierbefehl A und dessen zweiter Telegrammbestandteil die Adresse B enthält. Dieses Telegramm führt in dem ersten Schaltgerät 10 dazu, daß die Adresse B gesetzt wird und daß die Telegrammeinheit dieses Schaltgerät 10 ein Telegramm sendet, dessen erster Telegrammbestandteil die Adresse B und dessen zweiter Telegrammbestandteil die Zustandsinformation D und die Zusatzinformation E enthält.
2. Betrachtet wird nun ein Schaltgerät 10 mit der Adresse B, das ein Telegramm empfängt, dessen erster Telegrammbestandteil die Adresse B und dessen zweiter Telegrammbestandteil die Zusatzinformation E nicht enthält. Die Telegrammeinheit des entsprechenden Schaltgerätes 10 bearbeitet das empfangene Telegramm und sendet ein Telegramm, dessen erster Telegrammbestandteil die Adresse B und dessen zweiter Telegrammbestandteil die Zustandsinformation D und die Zusatzinformation E enthält.
3. Als nächstes wird wiederum ein Schaltgerät 10 betrachtet, das die Adresse B hat. Die Telegrammeinheit dieses Schaltgerätes 10 empfängt ein Telegramm, dessen erster Telegrammbestandteil die Adresse B enthält, während der zweite Telegrammbestandteil einen Bearbeitungsbefehl C enthält, die Zusatzinformation E jedoch nicht enthält. Die Telegrammeinheit dieses Schaltgerätes 10 arbeitet nun entsprechend dem Bearbeitungsbefehl C, führt beispielsweise eine Parametrierung durch, und sendet ein Telegramm, dessen erster Telegrammbestandteil die Adresse B und dessen zweiter Telegrammbestandteil die Zustandsinformation D und die Zusatzinformation E enthält.
4. Nun wird ein Schaltgerät 10 mit der Adresse B betrachtet, das ein Telegramm empfängt, dessen erster Telegrammbestandteil die Adresse B enthält und dessen zweiter Telegrammbestandteil die Zusatzinformation E enthält. Der Telegrammeinheit dieses Schaltgerätes 10 wird also mitgeteilt, daß das empfangene Telegramm bereits - von einem anderen Schaltgerät 10 - bearbeitet worden ist; das wird durch die Zusatzinformation E erkannt. Die Telegrammeinheit dieses Schaltgerätes 10 gibt nun ein Telegramm ab, dessen erster Telegrammbestandteil die Adressierinformation F enthält, während der zweite Telegrammbestandteil die Adresse B und die Zusatzinformation E enthält.
5. Betrachtet wird nun ein x-beliebiges Schaltgerät 10, das ein Telegramm empfängt, dessen erster Telegrammbestandteil die Adressierinformation F und dessen zweiter Telegrammbestandteil die Adresse B enthält. Die Telegrammeinheit dieses Schaltgerätes 10 gibt das empfangene Telegramm unverändert weiter; das gesendete Telegramm enthält also im ersten Telegrammbestandteil die Adressierinformation F und im zweiten Telegrammbestandteil die Adresse B.
6. Als nächstes wird nun ein Schaltgerät 10 betrachtet, das die Adresse B hat. Die Telegrammeinheit dieses Schaltgerätes 10 empfängt ein Telegramm, dessen erster Telegrammbestandteil den Adressierbefehl A und dessen zweiter Telegrammbestandteil die Adresse B enthält. Die Telegrammeinheit dieses Schaltgerätes 10 gibt ein Telegramm ab, dessen erster Telegrammbestand die Adresse B und dessen zweiter Telegrammbestandteil die Adressierinformation F enthält. Mit dem empfangenen Telegramm sollte ja die Adresse B gesetzt werden. Da jedoch die Adresse B bereits gesetzt ist, liegt ein Adressierfehler vor.
7. Betrachtet wird nur ein Schaltgerät 10, das eine x-beliebige Adresse, nicht jedoch die Adresse B hat. Dieses Schaltgerät 10 empfängt ein Telegramm, dessen erster Telegrammbestandteil die Adresse B und dessen zweiter Telegrammbestandteil die Zusatzinformation E enthält. Die Telegrammeinheit dieses Schaltgerätes 10 gibt ein Telegramm ab, das dem empfangenen Telegramm entspricht. Die Telegrammeinheit des entsprechenden Schaltgerätes 10 hat also erkannt, daß das Telegramm - mit der Adresse B - für ein anderes Überwachungs- und Erkennungsgerät 1 bestimmt ist.
8. Schließlich sei nochmals ein Schaltgerät 10 mit einer x-beliebigen Adresse, jedoch nicht mit der Adresse B betrachtet. Die Telegrammeinheit dieses Schaltgerätes 10 empfängt nun ein Telegramm, dessen erster Telegrammbestandteil den Adressierbefehl A und dessen zweiter Telegrammbestandteil die Adresse B enthält. Auch in diesem Fall sendet die Telegrammeinheit des Schaltgerätes 10 ein Telegramm, das exakt dem empfangenen Telegramm entspricht. Auch hier hat die Telegrammeinheit des Schaltgerätes 10 erkannt, daß das Telegramm für ein anderes Überwachungs- und Erkennungsgerät 1 bestimmt ist.

Abschließend sei zusammenfassend nochmals darauf hingewiesen, daß im Ausführungsbeispiel einer erfindungsgemäßen Schaltungsanordnung, das in Fig. 4 dargestellt ist, verwirklicht sind
a) eine Steuerschaltung, die dann in eine entsprechende Anlage eingreift, wenn ein sicherheitsrelevantes Kriterium erkannt worden ist, und
b) Abfrage- und Adressiermöglichkeiten.

Insgesamt ist erfindungsgemäß eine Schaltungsanordnung realisiert, die höchsten Sicherheitsanforderungen bei einem vergleichsweise geringen Verdrahtungsaufwand genügt und mit der ein aufgetretener Fehler ohne weiteres lokalisiert werden kann.

## Patentansprüche

1. Schaltungsanordnung zur Überwachung des fehlerfreien und/oder zur Erkennung eines fehlerbehafteten Zustands einer Anlage, z. B. einer Seilbahn- oder Sesselliftanlage, mit einer Mehrzahl von Überwachungs- und Erkennungsgeräten und mit mindestens einer Steuer- und Auswerteeinheit, wobei die Überwachungs- und Erkennungsgeräte als elektronische, berührungslos arbeitende Schaltgeräte ausgeführt sind, wobei die Schaltgeräte einen Anwesenheitsindikator und einen von dem Anwesenheitsindikator - ggf. über einen Schaltverstärker - steuerbaren elektronischen Schalter aufweisen und die Schaltgeräte hinsichtlich ihres Schaltzustandes abfragbar sind, nämlich hinsichtlich ihrer Schalterfunktion - Öffner oder Schließer - durch ein Umsteuersignal umsteuerbar sind,
**dadurch gekennzeichnet,**
**daß** die Schaltgeräte (10) miteinander und mit der Steuer- und Auswerteschaltung (11) in Serie geschaltet sind,
**daß** bei allen Schaltgeräten (10) der elektronische Schalter ausgangsseitig an einen Eingang (2) eines UND-Gliedes (3) angeschlossen ist und der andere Eingang (4) des UND-Gliedes (3) einen Steuereingang (5) und der Ausgang (6) des UND-Gliedes (3) den Ausgang (7) des Schaltgerätes (10) darstellen und
**daß** der Ausgang (7) des ersten Schaltgerätes (10) mit dem Steuereingang (5) des zweiten Schaltgerätes (10), der Ausgang (7) des zweiten Schaltgerätes (10) mit dem Steuereingang (5) des dritten Schaltgerätes (10) und der Ausgang (7) des (n-1)-ten Schaltgerätes (10) mit dem Steuereingang (5) des n-ten Schaltgerätes (10) verbunden sind.

2. Schaltungsanordnung nach Anspruch 1, **dadurch gekennzeichnet, daß** die Schaltgeräte (10) adressierbar sind.

3. Schaltungsanordnung nach Anspruch 1 oder 2, **dadurch gekennzeichnet, daß** die Schaltgeräte (10) und die Steuer- und Auswerteeinheit (11) hinsichtlich der Abfragemöglichkeit - über entsprechende Verbindungsleitungen (16) - einen Ring bilden, daß die Schaltgeräte (10) und die Steuer- und Auswerteeinheit (11) jeweils eine Telegrammeinheit aufweisen und daß die Telegrammeinheiten der Schaltgeräte (10) so ausgeführt sind, daß in ihnen eine Adresse speicherbar ist, daß sie ein empfangenes Telegramm bearbeiten können und daß sie ein empfangenes Telegramm, ggf. nach Bearbeitung, senden können.

4. Schaltungsanordnung nach Anspruch 3, **dadurch gekennzeichnet, daß** die Telegrammeinheiten nur dann funktionstüchtig sind, wenn an ihnen ein Freigabesignal anliegt.

5. Schaltungsanordnung nach einem der Ansprüche 1 bis 4, **dadurch gekennzeichnet, daß** die Schaltgeräte (10) einen - nicht sicherheitsrelevanten - Informationsausgang aufweisen und die Informationsausgänge aller Schaltgeräte (10) miteinander und mit der Steuer- und Auswerteeinheiten (11) verbunden sind.

6. Schaltungsanordnung nach einem der Ansprüche 1 bis 5, **dadurch gekennzeichnet, daß** jedes Schaltgerät (10) drei Anwesenheitsindikatoren bzw. Näherungsschalter aufweist und die Anwesenheitsindikatoren bzw. die Näherungsschalter ausgangsseitig - direkt oder indirekt - miteinander logisch verknüpft sind.

## Claims

1. Circuit for monitoring of the satisfactory state and/or detection of a faulty state of a system, for example, an aerial railway or chairlift system, with a plurality of monitoring and detection devices and with at least one control and evaluation unit, the monitoring and detection devices being made as electronic, contactless working switching devices, wherein the switching devices have a proximity indicator and an electronic switch, which can be controlled by the proximity switch - optionally using a switching amplifier - and the switching devices can be interrogated regarding their switch status, namely they can be re-routed using a re-routing signal regarding their switch function - make contact or break contact,
**characterized in**
**that** the switching devices (10) are connected in series with one another and with the control and evaluation unit (11),
**that** in all switching devices (10), the electronic switch is connected on the output side to the input (2) of an AND member (3) and the other input (4) of the AND member (3) represents a control input (5) and the output (6) of the AND member (3) represents an output (7) of the switching device and
**that** the output (7) of the first switching device (10) is connected to the control input (5) of the second switching device (10), the output (7) of the second switching device (10) with the control input (5) of the third switching device (10) and the output (7) of the (n-1)^{th} switching device (10) with the control input (5) of the n^{th} switching device (10).

2. Circuit according to claim 1, **characterized in that** the switching devices (10) are addressable.

3. Circuit according to claim 1 or 2, **characterized in that** the switching devices (10) and the control and evaluation unit (11) form a ring with respect to the interrogation possibility, via corresponding interconnecting cables (16), that each of the switching devices (10) and the control and evaluation unit (11) have a telegram unit and that the telegram units of the switching devices (10) are designed so that they have means for storing an address therein, that they are able to process a received telegram and are able to send a received telegram - if necessary after being processed.

4. Circuit according to claim 3, **characterized in that** the telegram units are only operable only when there is an enabling signal on them.

5. Circuit according to any one of claims 1 to 4, **characterized in that** the switching devices (10) have an information output for information unrelated to safety, and the information outputs of all switching devices (10) are connected to one another and to the control and evaluation unit (11).

6. Circuit according to any one of claims 1 to 5, **characterized in that** each switching device (10) has three proximity indicators or, respectively proximity switches, said proximity indicators, or respectively proximity switches being logically interconnected on an output side - either directly or indirectly.

## Revendications

1. Système de circuit pour la surveillance de l'état correct et/ou la détection d'un état défectueux d'une installation, par exemple d'une installation de téléphérique ou de télésiège, présentant une pluralité d'appareils de surveillance et de détection et au moins une unité de commande et d'exploitation, les appareils de surveillance et de détection étant réalisés sous la forme de dispositifs commutateurs électroniques fonctionnant sans contact, les dispositifs commutateurs présentant un indicateur de présence et un interrupteur électronique contrôlable par l'indicateur de présence -éventuellement par le biais d'un amplificateur de commutation- et les dispositifs commutateurs étant interrogeables sur leur état de commutation, à savoir leur fonction d'interrupteur -contact d'ouverture ou contact de fermeture-, c'est-à-dire étant permutables au moyen d'un signal de permutation de commande,
**caractérisé en ce que**
les dispositifs commutateurs (10) sont branchés en série entre eux et au dispositif de commande et d'exploitation (11),
que, dans tous les dispositifs commutateurs (10), l'interrupteur électronique est raccordé côté sortie à une entrée (2) d'un élément ET (3) et que l'autre entrée (4) de l'élément ET (3) représente une entrée de commande (5) et la sortie (6) de l'élément ET (3) représente la sortie (7) du dispositif commutateur (10) et
que la sortie (7) du premier dispositif commutateur (10) est raccordée à l'entrée de commande (5) du deuxième dispositif commutateur (10), la sortie (7) du deuxième dispositif commutateur (10) à l'entrée de commande (5) du troisième dispositif commutateur (10) et la sortie (7) du (n-1)ième dispositif commutateur (10) à l'entrée de commande (5) du n-ième dispositif commutateur (10).

2. Dispositif de circuit selon la revendication 1, **caractérisé en ce que** les dispositifs commutateurs (10) sont adressables.

3. Dispositif de circuit selon la revendication 1 ou 2, **caractérisé en ce que** les dispositifs commutateurs (10) et l'unité de commande et d'exploitation (11) forment une boucle au niveau de la possibilité d'interrogation -grâce à des lignes de liaison correspondantes (16)-, que les dispositifs commutateurs (10) et l'unité de commande et d'exploitation (11) présentent respectivement une unité de télégrammes et que les unités de télégrammes des dispositifs commutateurs (10) sont réalisées de manière à ce qu'une adresse y soit enregistrable, à ce qu'elles puissent traiter un télégramme reçu et à ce qu'elles puissent envoyer un télégramme reçu, le cas échéant après traitement.

4. Dispositif de circuit selon la revendication 3, **caractérisé en ce que** les unités de télégrammes ne sont fonctionnelles que si un signal de libération leur est appliqué.

5. Dispositif de circuit selon l'une quelconque des revendications 1 à 4, **caractérisé en ce que** les dispositifs commutateurs (10) présentent une sortie d'information -non sécurisée- et que les sorties d'information de tous les dispositifs commutateurs (10) sont raccordées entre elles et aux unités de commande et d'exploitation (11).

6. Dispositif de circuit selon l'une quelconque des revendications 1 à 5, **caractérisé en ce que** chaque dispositif commutateur (10) présente trois indicateurs de présence ou détecteurs de proximité et que les indicateurs de présence ou les détecteurs de proximité sont, côté sortie, rattachés les uns aux autres -directement ou indirectement- au niveau logique.
